# EUROPEAN PATENT SPECIFICATION

(11) **EP 3 850 400 B1**
(45) Date of publication and mention of the grant of the patent: **02.12.2026**
(21) Application number: 19763001.5
(22) Date of filing: 10.09.2019
(51) Int. Cl.: G01T 1/20, G01T 1/24, G01T 1/29

(54) **MULTI-PIECE MONO-LAYER RADIATION DETECTOR**
MEHRTEILIGER EINSCHICHTIGER STRAHLUNGSDETEKTOR
DÉTECTEUR DE RAYONNEMENT MONOCOUCHE À PIÈCES MULTIPLES

(30) Priority: 10.09.2018 EP 18193337
(43) Date of publication of application: 21.07.2021
(73) Proprietor: Koninklijke Philips N.V., 5656 AE Eindhoven (NL)
(72) Inventor: JACOBS, Johannes, Wilhelmus, Maria, 5656 AE Eindhoven (NL); BEHLING, Rolf, Karl, Otto, 5656 AE Eindhoven (NL); STEADMAN BOOKER, Roger, 5656 AE Eindhoven (NL); VOGTMEIER, Gereon, 5656 AE Eindhoven (NL); WIMMERS, Onno, Jan, 5656 AE Eindhoven (NL)
(74) Representative: Philips Intellectual Property & Standards
(86) International application number: PCT/EP2019/074036
(87) International publication number: WO 2020/053174

(56) References cited:
- DE-A1- 102007 058 447
- US-A1- 2010 135 463
- US-A1- 2013 051 521
- US-A1- 2014 110 586

## Description

### FIELD OF THE INVENTION

The invention relates to large-area pixelated radiation detectors, in particular the present invention relates to a radiation detector.

### BACKGROUND OF THE INVENTION

In recent years, new advanced X-ray and computed tomography, CT, applications are emerging, which require advanced imaging features such as spectral, also "multi-energy", imaging, higher dynamic range and higher spatial resolution. Examples are for instance spectral CT, spectral X-ray, differential phase contrast imaging, DPCI, dark field X-ray, DAX, imaging, and so-called multi-modality XSPECT imaging, a complete integration of SPECT - single photon emission computed tomography - and CT data during image reconstruction for sharp clinical detail and accurate measurement of disease.

Current X-ray and CT detectors have limited performance and cannot meet the required specification levels to enable these new applications at acceptable cost levels.

US 2002/054954 A1 describes a multidimensional detector array for detecting electromagnetic radiation, wherein a layer composite is produced, which has a sensor layer with a material sensitive to the radiation, and a carrier layer.

US 2010/0282972 A1 describes an indirect radiation detector for detecting radiation, the detector comprising: an array of pixels, each pixel being sub-divided into at least a first and a second sub-pixel, each sub-pixel having a cross-sectional area parallel to a surface plane of the array of pixels.

US 2010/0135463 A1 describes an X-ray image obtaining/imaging apparatus and method, wherein an X-ray image may be obtained using an X-ray sensor that is divided into pixel blocks including a plurality of pixels. Each pixel may respectively include a scintillator layer, with the scintillator layers having differing characteristics.

US 2013/0051521 A1 describes a detector device comprising an X-ray detector structure having a detection surface defining at least one separately addressable region for detecting incident X-ray radiation intensity thereon, wherein the separately addressable region is divided into a plurality of sub-regions provided on the detection surface each provided with a filter layer on the detection surface, the filter layers of a given separately addressable region comprising discrete and different materials with discrete defined and spectroscopically spaced X-ray absorption edges.

DE 10 2007 058 447 A1 describes an X-ray detector with a plurality of uniform detector elements, wherein each detector element is divided into several pixel areas. Differing filters are assigned to the differing pixel areas of a detector element that transmit a defined range of the energy spectrum of the X-ray radiation.

US 2014 0110586 A1 describes an X-ray detector. The detector includes a regular arrangement of image pixels including a plurality of detector pixels, wherein at least two of the detector pixels of an image pixel differ with regard to their sensitivity.

### SUMMARY OF THE INVENTION

There may be a need to facilitate the design and manufacture the radiation conversion in direct conversion detectors.

This need is met by the subject-matter of the independent claim 1. Further exemplary embodiments are evident from the dependent claims and the following description.

A first aspect of the invention relates to a radiation detector according to claim 1, comprising a substrate and a sensor, which is coupled to the substrate, the sensor comprising: a first array of sensor pixels; a second array of signal read-out elements; and an electronic circuitry which is configured to provide image data based on signals received from the signal read-out elements.

The radiation detector further comprises a transducer, which is coupled to the substrate and to the sensor, the transducer comprising: a third array of subpixels, wherein at least two subpixels are assigned to one sensor pixel. The second array of signal read-out elements and the third array of subpixels correspond to each other, wherein each of the subpixels comprises a radiation conversion material.

At least one of the signal read-out elements is a conductive electrode and the radiation conversion material of each of the subpixels is a photoconductor, wherein a composition of the photoconductor is varied between at least two subpixels assigned to one sensor pixel. The composition of the photoconductor to be varied between the at least two subpixels assigned to one sensor pixel is at least one of the following: i) a doping level of the photoconductor, ii) a doping material, and/or iii) a combination of doping materials.

The restriction that the second array of signal read-out elements and the third array of subpixels correspond to each other may be understood that the arrays correspond in size of the array as defined by the number of rows and columns that it contains.

The present invention advantageously uses the assembly concept of color display technologies for realization of (large-area) pixelated radiation detectors, i.e. replacing the flat panel display technology, as for instance realized by the so-called "microLED" by a radiation conversion material for X-ray / γ-ray detection and replacing the receiving substrate by a pixelated read-out sensor.

In the coming years the large display industry will rapidly develop the required process assembly technology and equipment for LED die (pick-and-place) transfer from donor substrates to receiving substrates.

Based on the present invention, medical detector suppliers can then easily reuse the developed microLED technologies to realize cost-effective manufacturing of multi-piece radiation detectors. A similar transfer of key enabling technologies occurred in the past for current a-Si and CMOS flat panel detectors, derived from respective displays, LCDs, and semiconductors, CMOS image sensors.

According to an embodiment of the invention, the photoconductor is at least one of the following: i) amorphous selenium, ii) cadmium zinc telluride, iii) cadmium telluride, iv) perovskite, v) gallium arsenide, vi) mercury(II)iodide, vii) lead(II) oxide, viii) thallium(I) bromide, and ix) inorganic photoconductor nanoparticles embedded in an organic matrix.

According to an embodiment of the invention, the at least two subpixels assigned to one sensor pixel are subpixels with different dimension and/or different size and/or different distance gaps.

According to an embodiment of the invention, the third array comprises a non-uniform distribution of the different dimension of the subpixels and/or the different size of the subpixels and/or the different distance gaps.

For example, according to an embodiment of the invention the non-uniform distribution of subpixels may be provided by a non-uniform distribution of the composition and/or the thickness of the used radiation conversion material.

For example, according to an embodiment of the invention the non-uniform distribution of subpixels may be provided by a non-uniform distribution of level of subpixel binning, for example 4x4, 3x3, 2x2 or 1x1 binning from a center region towards a periphery of detector.

According to an embodiment of the invention, this may be achieved by using equal pixel size across the complete detector area.

According to an embodiment of the invention, an increase of pixel size from center towards periphery may be provided. This advantageously results in high spatial resolution in center and lower resolution at periphery, while saving material costs of electronics compared to a detector with 4x4 subpixel binning across complete area.

According to an embodiment of the invention, the first array of sensor pixels and/or the second array of signal read-out elements and/or the third array of subpixels is a two-dimensional array.

According to an embodiment of the invention, the first array of sensor pixels and/or the second array of signal read-out elements and/or the third array of subpixels is a one-dimensional array.

According to an embodiment of the invention, the second array of signal read-out elements and the third array of subpixels define a subarray scheme of the first array of sensor pixels. In other words, at least a small portion in a center region of the detector is provided with subpixels.

According to an embodiment of the invention, the second array of signal read-out elements and the third array of subpixels are configured to provide a spatial resolution, a spectral energy resolution, or a dynamic range or a spectral energy range.

According to an embodiment of the invention, the substrate comprises a flat or a substantially flat or a curved shape. The term "substantially flat" as used by the present invention may refer to a flatness comprising a minimum bend radius of up to 1 cm.

According to an embodiment of the invention, the substrate comprises silicon, glass or polymer foil.

Further embodiments of the invention are provided in the description for explanatory purpose. These and other aspects of the invention will be apparent from and elucidated with reference to the embodiments described hereinafter.

### BRIEF DESCRIPTION OF THE DRAWINGS

A more complete appreciation of the invention and the attendant advantages thereof will be more clearly understood by reference to the following schematic drawings, which are not to scale, wherein:
Fig. 1 shows a schematic diagram of a radiation detector according to an embodiment of the invention.
Fig. 2 shows a schematic diagram of a radiation detector with an indirect detector not forming part of the claimed invention and a direct detector according to an embodiment of the invention.
Fig. 3 shows a schematic diagram for a read-out sensor according to an embodiment of the invention.
Fig. 4 shows a schematic diagram for pixel and subpixels for a radiation detector according to an embodiment of the invention.
Fig. 5 shows a basic pixel and subpixel design options.
Fig. 6 shows a schematic diagram for different pixel designs derived from base grids of 1x2, 1x3, 1x4, 2x2 and 2x3 subpixels according to an embodiment of the invention.
Fig. 7 shows a schematic diagram for different pixel designs derived from base 2D grids of 3x3, 4x4, 5x5, and 6x6 subpixels according to an embodiment of the invention.

In principle, identical parts are provided with the same reference symbols in the figures.

### DETAILED DESCRIPTION OF EMBODIMENTS

The illustration in the drawings is schematically and not to scale. In different drawings, similar or identical elements are provided with the same reference numerals.

Generally, identical parts, units, entities or steps are provided with the same reference symbols in the figures.

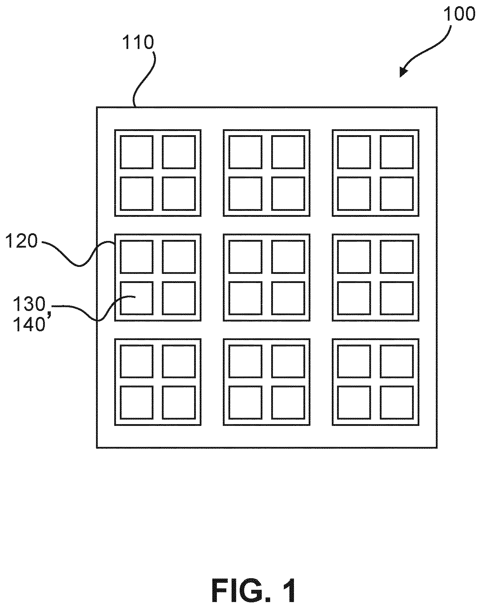

Fig. 1 shows a schematic diagram of a radiation detector according to an embodiment of the invention.

Fig. 1 shows a radiation detector 100 comprising: a substrate 110; a sensor, which is coupled to the substrate, the sensor comprising: a first array of sensor pixels 120, a second array of signal read-out elements 130; and an electronic circuitry which is configured to provide image data based on signals received from the signal read-out elements.

The radiation detector 100 further comprises a transducer, which is coupled to the substrate and to the sensor, the transducer comprising: a third array of subpixels 140, wherein for the shown embodiment of Fig. 1 four subpixels are assigned to one sensor pixel, and also four read-out elements 130 are assigned to one sensor pixel, wherein each of the subpixels comprises a radiation conversion material.

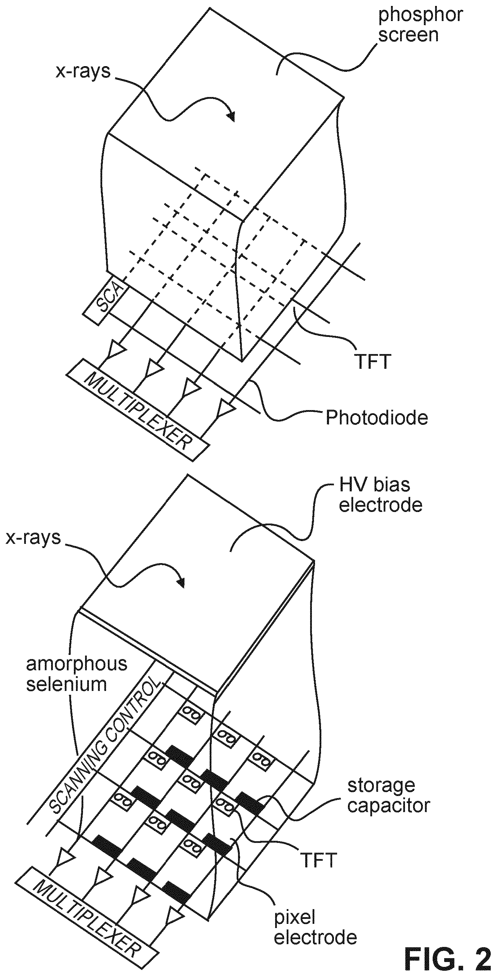

Fig. 2 shows a schematic diagram of a radiation detector with an indirect detector not forming part of the claimed invention and a direct detector according to an embodiment of the invention.

According to an embodiment of the invention, provided is a method to design and manufacture the radiation conversion layer in direct conversion detectors. Indirect detector as shown on the left side of Fig. 2 provide that the conversion material is formed by a scintillator, the pixel read-out element is for instance realized in terms of a photodiode.

According to the claimed invention, the direct detector as shown on the right side of Fig. 2 is provided by using as the conversion material a photoconductor, the pixel read-out element is then realized in terms of a conductive electrode or in terms of metal electrode. According to an embodiment of the invention, a common HV bias electrode is applied on the opposite side of the photoconductor to realize an electric field across the photoconductor.

According to an embodiment of the invention, the detector comprises a read-out sensor, i.e. a one-dimensional array or two-dimensional array of addressable pixels comprising at least an electronic switch and a signal read-out element.

According to an embodiment of the invention, the electronic switches may be provided in terms of thin-film transistors.

According to an embodiment of the invention, the sensor and each pixel, for instance also each subpixel, may comprise additional electronic circuitry, as for instance elements like capacitors, amplifiers, comparators, analog-to-digital converter or any further digital or analog signal processing circuit.

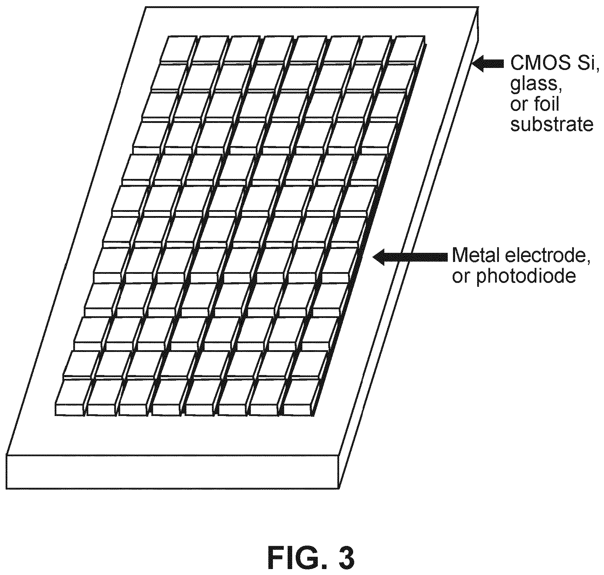

Fig. 3 shows a schematic diagram for a read-out sensor.

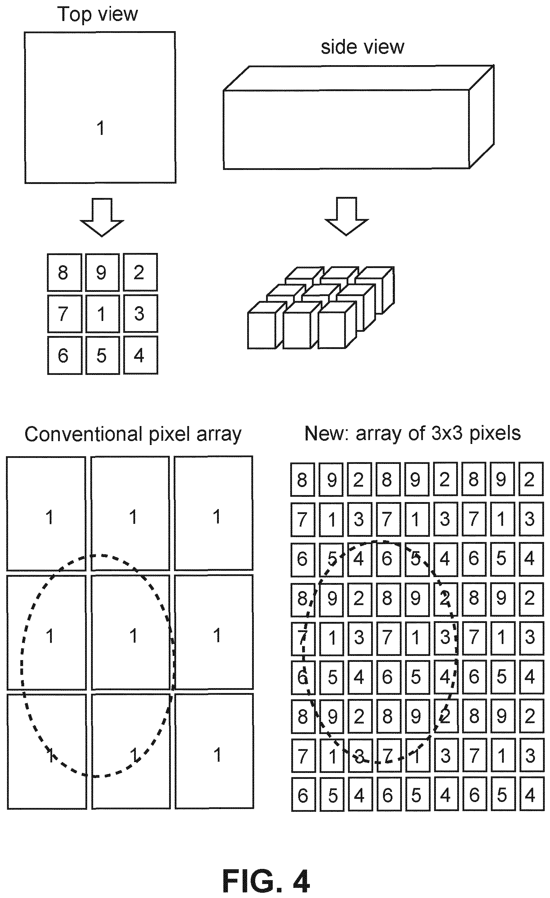

Fig. 4 shows a schematic diagram for pixel and subpixels for a radiation detector according to an embodiment of the invention. The basic idea is to replace this standard pixel by a pixel composed of multiple small subpixels composed of different radiation conversion materials, as shown in Fig. 4.

Fig. 4 shows the approach from pixel to subpixels. Conventional detector as shown on the left provides that a pixel is composed of single conversion material. The detector as defined by the present invention provides that a pixel at least comprises multiple subpixels wherein a composition of the photoconductor is varied. The circle depicts an incident X-ray spot on the detector.

According to an embodiment of the invention, the design of the pixels, the sensor and related detector electronics may be implemented according to demands of the radiation detector, although it will be determined to a large extent by the chosen design of the radiation conversion layer.

According to an embodiment of the invention, the signals from subpixels can be separated from each other by means of an electrically isolating layer in the gap between photoconductor pieces.

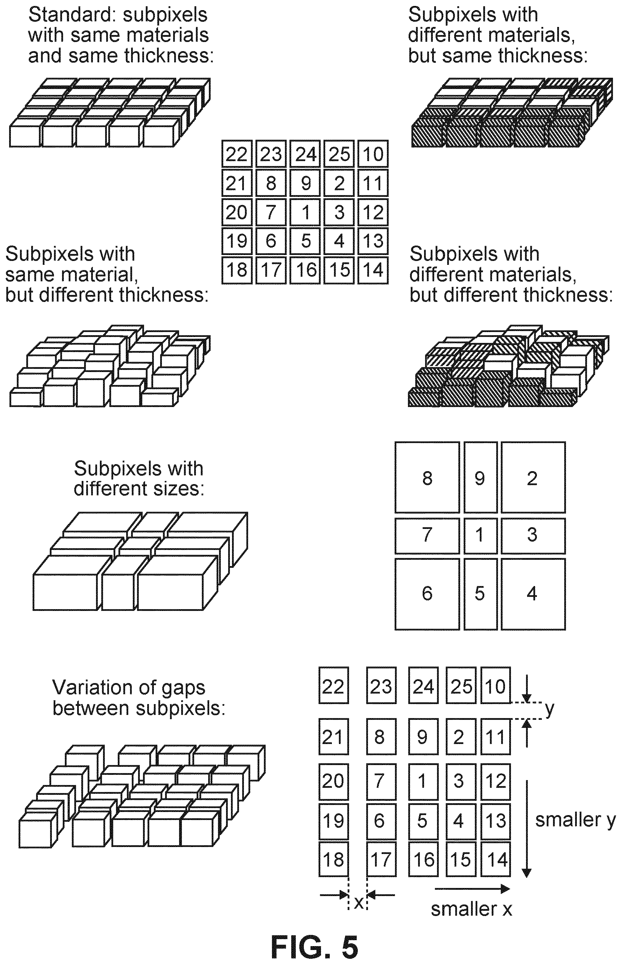

Fig. 5 shows a basic pixel and subpixel design options as illustrative examples. The scope of the invention is defined by the claims.

Different pixel designs can be configured by combining subpixels according to one or more of the following basic options, as schematically illustrated in Fig. 5:
i. Subpixels with different material composition, but same thickness;
ii. Subpixels with same material but different thickness, not forming part of the claimed invention;
iii. Subpixels with different material composition, and different thickness;
iv. Subpixels with different sizes in x-y direction;
v. Subpixels with different distance (gaps in x-y direction) between each other.

According to an embodiment of the invention, each subpixel may be individually capable of receiving image data signals from the piece of radiation conversion material to which it is connected. Each signal of a subpixel may be processed as in a standard detector to form an output image that can be transferred to a data handling unit for further image processing.

According to an embodiment of the invention, alternatively, multiple signals from subpixel(s) within a pixel and/or neighboring pixel(s) are binned together to form an output image. In this way, pixel designs can be configured to improve one or more specific functions or performance features of the detector, such as spatial resolution, spectral energy resolution, dynamic range or spectral energy range.

For example, the circle in Fig. 4 illustrates that spatial resolution increases at decreasing size of subpixels. By combining large with small subpixels, the dynamic range of the detector can be improved.

For the requirement of a spatial resolution for an X-ray or a CT detector, for instance, smaller subpixels are provided with different photoconductor materials. This may be used in applications like DPCI or DAX imaging, direct fringe measurements or for achieving small and smallest pixels for X-ray or a CT system.

For the requirement of a spectral differentiation or resolution for an X-ray or a CT detector, for instance, subpixels are provided with a large variation of different dedicated photoconductor materials. This may be used in applications like tissue differentiation, material detection and separation, or non-invasive measurements of X-ray tube characteristics - for instance an X-ray spot size, or an X-ray spectrum - of an X-ray or a CT imaging system.

According to an embodiment of the invention, for the requirement of a dynamic differentiation or resolution for an X-ray or a CT detector, for instance, subpixels are provided with a combination of small and large subpixels, e.g. the size of at least two subpixels may be varied within one pixel. This may be used in applications like high contrast images of medical tissue or objects with very large differences in the material X-ray absorption characteristics.

According to an embodiment of the invention, also hybrid counting may be applied and integrating detectors may be used, also pixels or subpixels with alternating photoconductor type or material or doping may be used and scintillator materials for photon counting in the low dose regime and charge integration for the high dose regime may be used, wherein low dose regime defines a dose regime below a certain specified threshold value and high dose regime defines a dose regime above a further, specified threshold value.

A further approach may be based on using a hybrid X-ray and γ-ray detector, wherein pixels or subpixels with different photoconductor materials are used for combined X-ray and SPECT imaging.

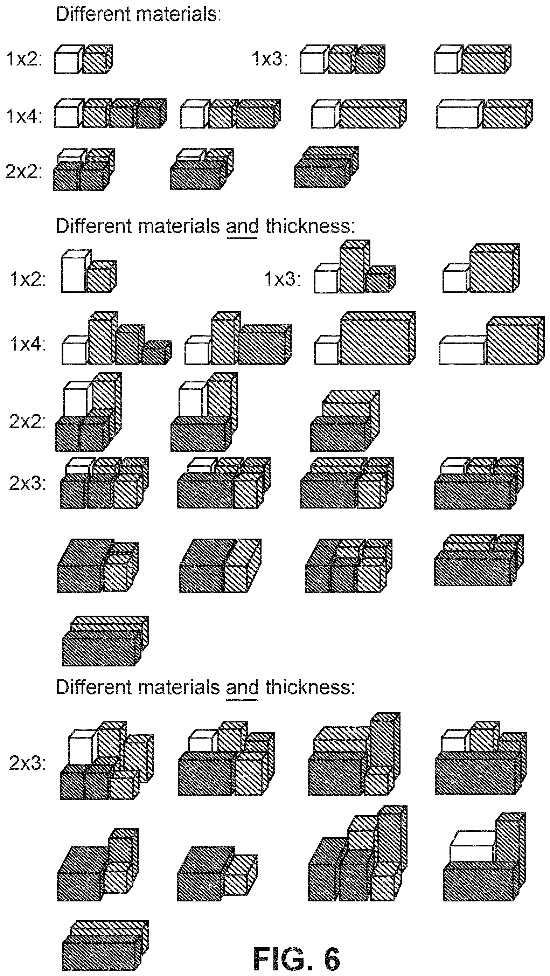

Fig. 6 shows a schematic diagram for different pixel designs derived from base grids of 1x2, 1x3, 1x4, 2x2 and 2x3 subpixels according to an embodiment of the invention.

Fig. 6 illustrates that the number of possible different pixel designs increases rapidly when the number of subpixels in a pixel increases. For example, for a pixel composed of 2x3 subpixels on a base two-dimensional grid with fixed sizes, already 9 different pixel designs are possible when only subpixel binning and material type as design parameters are being varied. It is clear that the number of possible different pixel designs becomes infinite, when also material thickness, subpixel sizes and distance gaps between subpixels are being varied.

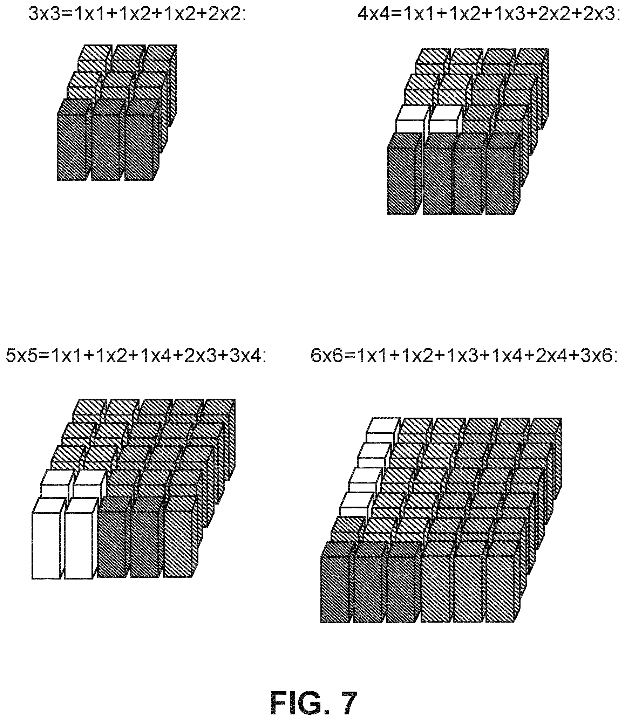

Fig. 7 shows a schematic diagram for different pixel designs derived from base two-dimensional, 2D, grids of 3x3, 4x4, 5x5, and 6x6 subpixels according to an embodiment of the invention.

Fig. 7 shows, for each base two-dimensional grid of 3x3, 4x4, 5x5, and 6x6 subpixels, an illustrative combination of subpixels that creates a pixel with very high dynamic range, HDR. Subpixels with the same pattern can be either electronically binned or physically combined to a larger subpixel.

According to an embodiment of the invention, for example, from the base two-dimensional grid of 6x6 subpixels a HDR pixel can be configured composed of six subpixels with increasing surface areas (1, 2, 3, 4, 8, and 18) in order to ensure sufficient overlap in electrical gain.

According to an embodiment of the invention, for X-ray and CT detectors we anticipate that subpixel sizes may range between 5 µm and 1 mm, and preferably between 10 µm and 100 µm.

According to an embodiment of the invention, the pick-and-place assembly method may enable manufacturing of a non-uniform detector composed of a sensor with different pixel areas or a gradient in surface area properties, e.g. increasing pixel size or subpixel size from center towards edges or decreasing pixel size or subpixel size from center towards edges.

According to an embodiment of the invention, a standard detector may be provided with only a certain specified portion or part of the pixel area, e.g. in the center, of the sensor equipped with certain features or characteristics, for instance a high-resolution zoom-in in certain parts or areas of the sensor for security application, like for instance for luggage inspection.

| Pixel shape/size | 1x2 | 1x3 | 1x3 | 1x4 | 1x4 | 1x4 | 1x4 | 2x2 | 2x2 | 2x2 |
|---|---|---|---|---|---|---|---|---|---|---|
| Material/height A | 1 | 1 | 1 | 1 | 1 | 1 | 2 | 1 | 1 | 2 |
| MaterialB/height B | 1 | 1 | 2 | 1 | 1 | 3 | 2 | 1 | 1 | 2 |
| MaterialC/height C | | 1 | | 1 | 2 | | | 1 | 2 | |
| MateriaID/Height D | | | | 1 | | | | 1 | | |
| MaterialE/Height E | | | | | | | | | | |
| MaterialF/Height F | | | | | | | | | | |
| MaterialG/Height G | | | | | | | | | | |
| # subpixels | 2 | 3 | 3 | 4 | 4 | 4 | 4 | 4 | 4 | 4 |

| 2x3 | 2x3 | 2x3 | 2x3 | 2x3 | 2x3 | 2x3 | 2x3 | 2x3 | 3x3 | 4x4 | 5x5 | 6x6 |
|---|---|---|---|---|---|---|---|---|---|---|---|---|
| 1 | 1 | 1 | 1 | 1 | 2 | 2 | 2 | 3 | 1 | 1 | 1 | 1 |
| 1 | 1 | 1 | 1 | 1 | 1 | 1 | 4 | 3 | 2 | 2 | 2 | 2 |
| 1 | 1 | 2 | 1 | 4 | 1 | 3 | | | 2 | 3 | 4 | 3 |
| 1 | 1 | 2 | 3 | | 1 | | | | 4 | 4 | 6 | 4 |
| 1 | 2 | | | | 1 | | | | | 6 | 12 | 8 |
| 1 | | | | | | | | | | | | 18 |
| 6 | 6 | 6 | 6 | 6 | 6 | 6 | 6 | 6 | 9 | 16 | 25 | 36 |

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practicing the claimed invention, from a study of the drawings, the disclosure, and the appended claims.

**In** the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A radiation detector (100) comprising:
i) a substrate (110);
ii) a sensor, which is coupled to the substrate, the sensor comprising:
- a first array (120) of sensor pixels;
- a second array (130) of signal read-out elements; and
- an electronic circuitry which is configured to provide image data based on signals received from the signal read-out elements;
iii) a transducer, which is coupled to the substrate and to the sensor, the transducer comprising:
- a third array (140) of subpixels, wherein at least two subpixels are assigned to one sensor pixel; wherein the second array of signal read-out elements and the third array of subpixels correspond to each other; wherein each of the subpixels comprises a radiation conversion material,
wherein at least one of the signal read-out elements is a conductive electrode and the radiation conversion material of each of the subpixels is a photoconductor,
wherein a composition of the photoconductor is varied between at least two subpixels assigned to one sensor pixel, and
**characterized in that** the composition of the photoconductor to be varied between the at least two subpixels assigned to one sensor pixel is at least one of the following: i) a doping level of the photoconductor, ii) a doping material, and/or iii) a combination of doping materials.

2. The radiation detector according to claim 1,
wherein the photoconductor is at least one of the following: i) amorphous selenium, ii) cadmium zinc telluride, iii) cadmium telluride, iv) perovskite, v) gallium arsenide, vi) mercury(II)iodide, vii) lead(II) oxide, viii) thallium(I) bromide, and ix) inorganic photoconductor nanoparticles embedded in an organic matrix.

3. The radiation detector according to any one of the preceding claims,
wherein the at least two subpixels assigned to one sensor pixel are subpixels with different dimension and/or different size and/or different distance gaps.

4. The radiation detector according to claim 3,
wherein the third array comprises a non-uniform distribution of the different dimension of the subpixels and/or the different size of the subpixels and/or the different distance gaps.

5. The radiation detector according to any one of the preceding claims,
wherein the first array of sensor pixels and/or the second array of signal read-out elements and/or the third array of subpixels is a two-dimensional array.

6. The radiation detector according to any one of the preceding claims,
wherein the first array of sensor pixels and/or the second array of signal read-out elements and/or the third array of subpixels is a one-dimensional array.

7. The radiation detector according to any one of the preceding claims,
wherein the second array of signal read-out elements and the third array of subpixels define a subarray scheme of the first array of sensor pixels.

8. The radiation detector according to any one of the preceding claims,
wherein the second array of signal read-out elements and the third array of subpixels are configured to provide a spatial resolution, a spectral energy resolution, or a dynamic range or a spectral energy range.

9. The radiation detector according to any one of the preceding claims,
wherein the substrate comprises a flat or a substantially flat or a curved shape.

10. The radiation detector according to any one of the preceding claims,
wherein the substrate comprises silicon, glass or polymer foil.

## Patentansprüche

1. Strahlungsdetektor (100), umfassend:
i) ein Substrat (110);
ii) einen Sensor, der mit dem Substrat gekoppelt ist, wobei der Sensor umfasst:
- ein erstes Array (120) von Sensorpixeln;
- ein zweites Array (130) von Signalausleseelementen; und
- eine elektronische Schaltungsanordnung, die konfiguriert ist zum Bereitstellen von Bilddaten basierend auf Signalen, die von den Signalausleseelementen empfangen werden;
iii) einen Wandler, der mit dem Substrat und mit dem Sensor gekoppelt ist, wobei der Wandler umfasst:
- ein drittes Array (140) von Subpixeln, wobei mindestens zwei Subpixel einem Sensorpixel zugeordnet sind; wobei das zweite Array von Signalausleseelementen und das dritte Array von Subpixeln einander entsprechen;
wobei jedes der Subpixel ein Strahlungsumwandlungsmaterial umfasst,
wobei mindestens eines der Signalausleseelemente eine leitfähige Elektrode ist und wobei das Strahlungsumwandlungsmaterial von jedem der Subpixel ein Fotoleiter ist,
wobei eine Zusammensetzung des Fotoleiters zwischen mindestens zwei Subpixeln variiert wird, die einem Sensorpixel zugeordnet sind, und
**dadurch gekennzeichnet, dass** die Zusammensetzung des Fotoleiters, der zwischen den mindestens zwei Subpixeln variiert wird, die einem Sensorpixel zugeordnet sind, mindestens eine der Folgenden ist: i) ein Dotierungsgrad des Fotoleiters, ii) ein Dotierungsmaterial und/oder iii) eine Kombination von Dotierungsmaterialien.

2. Strahlungsdetektor nach Anspruch 1,
wobei der Fotoleiter mindestens eines der Folgenden ist: i) amorphes Selen, II) Cadmiumzinktellurid, III) Cadmiumtellurid, IV) Perowskit, v) Galliumarsenid, VI) Quecksilber(II)-jodid, vii) Blei(II)-oxid, viii) Thallium(I)-bromid und ix) anorganische Fotoleiter-Nanopartikel, die in eine organische Matrix eingebettet sind.

3. Strahlungsdetektor nach einem der vorhergehenden Ansprüche,
wobei die mindestens zwei Subpixel, die einem Sensorpixel zugeordnet sind, Subpixel mit unterschiedlichen Abmessungen und/oder unterschiedlichen Größen und/oder unterschiedlichen Abstandslücken sind.

4. Strahlungsdetektor nach Anspruch 3,
wobei das dritte Array eine ungleichmäßige Verteilung der unterschiedlichen Abmessungen der Subpixel und/oder der unterschiedlichen Größen der Subpixel und/oder der unterschiedlichen Abstandslücken umfasst.

5. Strahlungsdetektor nach einem der vorhergehenden Ansprüche,
wobei das erste Array von Sensorpixeln und/oder das zweite Array von Signalausleseelementen und/oder das dritte Array von Subpixeln zweidimensionale Arrays sind.

6. Strahlungsdetektor nach einem der vorhergehenden Ansprüche,
wobei das erste Array von Sensorpixeln und/oder das zweite Array von Signalausleseelementen und/oder das dritte Array von Subpixeln eindimensionale Arrays sind.

7. Strahlungsdetektor nach einem der vorhergehenden Ansprüche,
wobei das zweite Array von Signalausleseelementen und das dritte Array von Subpixeln ein Teilarray-Schema des ersten Arrays von Sensorpixeln definieren.

8. Strahlungsdetektor nach einem der vorhergehenden Ansprüche,
wobei das zweite Array von Signalausleseelementen und das dritte Array von Subpixeln konfiguriert sind zum Bereitstellen einer räumlichen Auflösung, einer spektralen Energieauflösung oder eines Dynamikbereichs oder eines spektralen Energiebereichs.

9. Strahlungsdetektor nach einem der vorhergehenden Ansprüche,
wobei das Substrat eine flache oder eine im Wesentlichen flache oder eine gekrümmte Form umfasst.

10. Strahlungsdetektor nach einem der vorhergehenden Ansprüche,
wobei das Substrat Silicium, Glas oder eine Polymerfolie umfasst.

## Revendications

1. Détecteur de rayonnement (100) comprenant :
i) un substrat (110) ;
ii) un capteur, qui est couplé au substrat, le capteur comprenant :
- un premier réseau (120) de pixels de capteurs,
- un deuxième réseau (130) d'éléments de lecture de signaux ; et
- un circuit électronique qui est configuré pour fournir des données d'image à partir de signaux reçus depuis les éléments de lecture de signaux ;
iii) un transducteur, qui est couplé au substrat et au capteur, le transducteur comprenant :
- un troisième réseau (140) de sous-pixels, dans lequel au moins deux sous-pixels sont affectés à un pixel de capteur ; dans lequel le deuxième réseau d'éléments de lecture de signaux et le troisième réseau de sous-pixels se correspondent entre eux ; dans lequel chacun des sous-pixels comprend un matériau de conversion de rayonnement,
dans lequel au moins l'un des éléments de lecture de signaux est une électrode conductrice et le matériau de conversion de rayonnement de chacun des sous-pixels est un photoconducteur,
dans lequel on fait varier une composition du photoconducteur entre au moins deux sous-pixels affectés à un pixel de capteur, et
**caractérisé en ce que** la composition du photoconducteur à faire varier entre les au moins deux sous-pixels affectés à un pixel de capteur est au moins l'une des suivantes : i) un niveau de dopage du photoconducteur, ii) un matériau dopant, et/ou iii) une combinaison de matériaux dopants.

2. Détecteur de rayonnement selon la revendication 1, dans lequel le photoconducteur est au moins l'un des suivants : i) du sélénium amorphe, ii) du tellurure de zinc et de cadmium, iii) du tellurure de cadmium, iv) de la pérovskite, v) de l'arséniure de gallium, vi) de l'iodure de mercure (II), vii) de l'oxyde de plomb (II), viii) du bromure de thallium I), et ix) des nanoparticules inorganiques photoconductrices noyées dans une matrice organique.

3. Détecteur de rayonnement selon l'une quelconque des revendications précédentes,
dans lequel les au moins deux sous-pixels affectés à un pixel de capteur sont des sous-pixels ayant des dimensions différentes et/ou des tailles différentes et/ou des espacements différents.

4. Détecteur de rayonnement selon la revendication 3,
dans lequel le troisième réseau comprend une répartition non uniforme de la dimension différente des sous-pixels et/ou de la taille différente des sous-pixels et/ou des espacements différents.

5. Détecteur de rayonnement selon l'une quelconque des revendications précédentes,
dans lequel le premier réseau de pixels de capteurs et/ou le deuxième réseau d'éléments de lecture de signaux et/ou le troisième réseau de sous-pixels est un réseau à deux dimensions.

6. Détecteur de rayonnement selon l'une quelconque des revendications précédentes,
dans lequel le premier réseau de pixels de capteurs et/ou le deuxième réseau d'éléments de lecture de signaux et/ou le troisième réseau de sous-pixels est un réseau à une dimension.

7. Détecteur de rayonnement selon l'une quelconque des revendications précédentes,
dans lequel le deuxième réseau d'éléments de lecture de signaux et le troisième réseau de sous-pixels définissent un schéma de sous-réseau du premier réseau de pixels de capteurs.

8. Détecteur de rayonnement selon l'une quelconque des revendications précédentes,
dans lequel le deuxième réseau d'éléments de lecture de signaux et le troisième réseau de sous-pixels sont configurés pour fournir une résolution spatiale, une résolution spectrale d'énergie, ou une plage dynamique ou une plage spectrale d'énergie.

9. Détecteur de rayonnement selon l'une quelconque des revendications précédentes,
dans lequel le substrat comporte une forme plane ou sensiblement plane ou une forme incurvée.

10. Détecteur de rayonnement selon l'une quelconque des revendications précédentes,
dans lequel le substrat comprenant une feuille de silicium, de verre ou de polymère.
